# EUROPEAN PATENT APPLICATION

(11) **EP 1 156 709 A1**
(43) Date of publication of application: **21.11.2001**
(21) Application number: 99961286.4
(22) Date of filing: 09.12.1999
(51) Int. Cl.: H05K 3/20

(54) **METHOD OF FORMING TRANSFERABLE PRINTED PATTERN, AND GLASS WITH PRINTED PATTERN**

(30) Priority: 07.09.1999 JP 25338899
(71) Applicant: ASAHI GLASS COMPANY LTD., Tokyo 100-8405 (JP)
(72) Inventor: SUNAHARA, Kazuo, Yokohama-shi Kanagawa 222-0033 (JP); NAKAYAMA, Katsuyoshi, Asahi Glass Company Ltd., Yokohama-shi, Kanagawa 221-8755 (JP); KIDERA, Nobutaka, Asahi Glass Company Ltd., Yokohama-shi, Kanagawa 221-8755 (JP)
(74) Representative: Müller-Boré & Partner Patentanwälte
(86) International application number: JP9906906
(87) International publication number: WO0119147

(57) **Abstract**

On a transfer paper having a release layer formed on its surface, an electric circuit is formed by screen printing, and this electric circuit is thermally transferred onto a substrate made of e.g. glass. To carry out this thermal transfer, the transfer paper is pressed by a pressing plate and heated while pressing the electric circuit pattern against the substrate. The substrate having the electric circuit pattern thus transferred, is heated and baked to remove a thermoplastic resin contained in the electric circuit pattern and at the same time to bake the electric circuit pattern to the substrate. Thus, a desired electric circuit can be formed on the substrate.

## Description

### TECHNICAL FIELD

The present invention relates to a method for forming a transfer type print pattern, whereby a print pattern of e.g. an electric circuit, an electronic component or a light-shielding pattern, is formed by transfer on a substrate made of e.g. glass, and a glass having a print pattern formed by this method.

### BACKGROUND ART

Various types are employed as a system for forming a pattern of e.g. an electric circuit on a substrate. For example, for semiconductor elements, a
photolithography/etching method is employed. This method is excellent in processing fine patterns of a submicron order.

However, to carry out this method, a large size complex installation will be required, such that a clean room will be required. Further, the etching time is long, and particularly when a multi-layered electric circuit is to be formed, the production time tends to be long. With respect to the thickness of the layer to be formed, there is no problem in the case of a layer having a thickness of not more than a submicron, but to form a layer of at least a few µ, there is a problem that it takes time.

Further, for the purpose of imparting a functionality to the surface of a substrate, a spattering method is also practically employed. By this method, it is possible to form a thin layer on a substrate surface from a small area to a large area uniformly in a thickness of not more than a submicron. However, it is difficult to control gas molecules by an electric field in a closed space, and patterning to form a circuit tends to be difficult. Further, there is a problem that the productivity is low, and the cost is high.

Therefore, a screen printing method may sometimes be employed, which is capable of drawing a layer thickness of from few µm to a few hundred µm at a high speed with a precision of a few tens µm even under a rough environmental condition with a low clean degree, although it does not have such a high precision drawing performance as the photolithography/etching method. By this method, a multi-layered electric circuit can be printed, and thus it is widely used for e.g. electronic components or printed circuits. Further, even when compared with a spattering method, it is excellent in that the patterning efficiency and the productivity are high, and the cost is low.

However, the above conventional screen printing method has had a problem that when a print pattern of e.g. a multi-layered electric circuit or a light-shielding pattern of a small area is to be formed on a substrate with a large area, it is required to carry out positioning or to carry out multi-layer printing, while securing a high level of the positional precision of the substrate, and a large scale drying installation or a positioning apparatus with high precision, is required, whereby the costs tend to be high.

Accordingly, it is conceivable that an element such as a chip component is attached on a substrate to form an electric circuit. However, the element itself has a size of about a few mm which is equal or thicker than the substrate of e.g. glass, and there has been a problem that mountability on the substrate is impaired.

Thus, the conventional screen printing method had a problem such that it is difficult to form a print pattern such as a thin film electric circuit or a light-shielding pattern on a substrate having a large area.

The present invention has been made in view of the above-described conventional problems, and its object is to present a method for forming a transfer type print pattern, whereby a print pattern such as a thin film electric circuit or a light-shielding pattern can be formed simply and with high precision on a substrate having a large area.

### DISCLOSURE OF THE INVENTION

In order to accomplish the above object, the present inventors have conducted various studies and have developed a transfer technique which is used in the muffle painting in the field of china, whereby the present invention has been accomplished. In order to carry out muffle painting on a conventional china, a transfer paper is employed which has a three layer structure comprising a base paper, a water-soluble glue and an organic film of e.g. polyethylene, and a predetermined paste is printed in a desired pattern on an organic film by a screen printing method, to form an image, which is then dried. This paste is one prepared by forming a kneaded material comprising an inorganic pigment and a glaze made of a glass powder into a paste by means of an organic vehicle and a solvent.

The transfer paper having an image thus formed, is immersed in water to separate the base material paper and the organic film having a pattern formed thereon, whereupon the organic film is bonded to a china as a substrate by the adhesiveness of the water-soluble glue, followed by drying. Further, in the step of heat treatment of the substrate, the organic film is thermally decomposed and vaporized, and the pattern is baked to the china, whereby the transfer of the image is carried out.

However, if this technique is applied as it is, for example, to an electric circuit or an electronic component, there will be a problem that in the step of immersion in water in the transfer process, the metal constituting the electric circuit undergoes deterioration due to e.g. water. Therefore, in the present invention, a glass paste is used, so that the transfer can be carried out without immersion in water of the transfer paper having an electric circuit or the like formed. Namely, in the present invention, a pattern of e.g. an electric circuit, is transferred on a substrate by thermal transfer. The glass paste in the present invention comprises at least a low melting point glass powder, an organic binder and a solvent (a volatile solvent). The above organic binder is preferably a thermoplastic resin which melts, decomposes and evaporates in the step of baking the glass paste. Further, as optional components depending upon the particular applications, a filler such as an alumina powder or a zirconia powder to adjust the expansion coefficient, a conductive material such as a silver powder to impart electrical conductivity, an inorganic heat resistant pigment to impart a light-shielding function, a dielectric constant ceramic powder or a low dielectric constant ceramic powder to adjust the dielectric constant, or other materials such as an insulating material, a semiconductor material, a resistance material, a magnetic material, etc., may be incorporated.

The present invention as described in the foregoing, is a method for forming a transfer type print pattern, which comprises forming a print pattern on a transfer film by a glass paste, thermally transferring the print pattern onto a substrate, and baking the print pattern thermally transferred onto the substrate. Here, the pattern of the print pattern may, for example, be an electric circuit pattern, a colored pattern, a light-shielding pattern.

Further, in the above method for forming a transfer type print pattern, the print pattern formed on the transfer film comprises at least one member selected from a conductive material, an insulating material, a dielectric material, a semiconductor material, a resistance material, a magnetic material and an inorganic heat-resistant pigment, and a thermoplastic resin which melts, decomposes and evaporates in the baking step.

Here, the conductive material is, for example, a metal such as silver, copper, platinum, gold or palladium, or a conductive oxide such as ITO; the insulating material is, for example, an oxide such as SiO₂ or MgO; the dielectric material is, for example, an oxide such as BaTiO₃; the semiconductor material is, for example, a semiconductor such as Si or GaAs; the resistance material is a conductor such as a metal, a material other than the conductor, or a mixture thereof; and the magnetic material is, for example, a metal such as Fe, an alloy such as FeNiCo, or an oxide such as ferrite. The inorganic heat resistant pigment is, for example, copper/chromium oxide, iron/manganese oxide or magnetite.

Further, in the above method for forming a transfer type print pattern, the thermoplastic resin is one member or a blend resin of two or more members, selected from a thermoplastic polyester resin, a thermoplastic cellulose derivative, a thermoplastic acrylic resin and a thermoplastic vinyl acetate resin.

Further, in the above method for forming a transfer type print pattern, the print pattern formed on the transfer film is in one layer or in a laminated structure of two or more layers.

Further, in the above method for forming a transfer type print pattern, the substrate is made of glass or ceramics.

Further, in the above method for forming a transfer type print pattern, an adhesion aid is preliminarily coated on the print pattern formed on the transfer film.

Further, in the above method for forming a transfer type print pattern, an adhesion aid is preliminarily coated on the print pattern formed on the transfer film, and when the decomposition temperature of the adhesion aid is represented by T₁, the decomposition temperature of the thermoplastic resin is represented by T₂ and the sintering initiation temperature of the glass paste is represented by T₃, (T₁-T₂) is from 5°C to 20°C, and (T₃-T₁) is 10°C or higher.

Further, in the above method for forming a transfer type print pattern, the print pattern is an electric circuit pattern. Here "the print pattern is an electric circuit pattern" means that the pattern of the print pattern thermally transferred onto the substrate, is an electric circuit pattern.

Further, the present invention also provides a glass having a print pattern formed, wherein the print pattern is formed on one member selected from a glass for automobiles, a glass for buildings and a glass for displays, by the above-mentioned method for forming a transfer type print pattern.

According to each of the above-mentioned constructions, a print pattern preliminarily formed on a transfer paper, is transferred onto a substrate without directly printing and drying print patterns sequentially in multilayers on a substrate of e.g. glass, whereby a highly precise print pattern can be formed. The print pattern thus formed can be integrated with the substrate by the thermal treatment of the substrate.

### BRIEF DESCRIPTION OF THE DRAWINGS

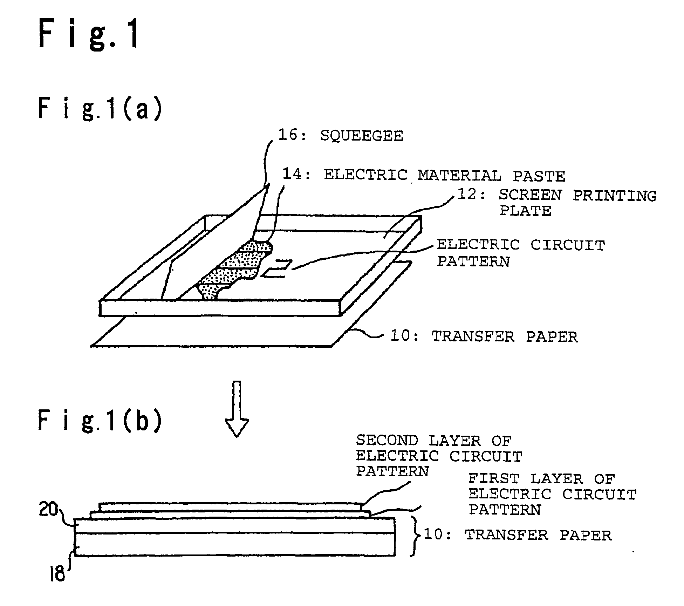

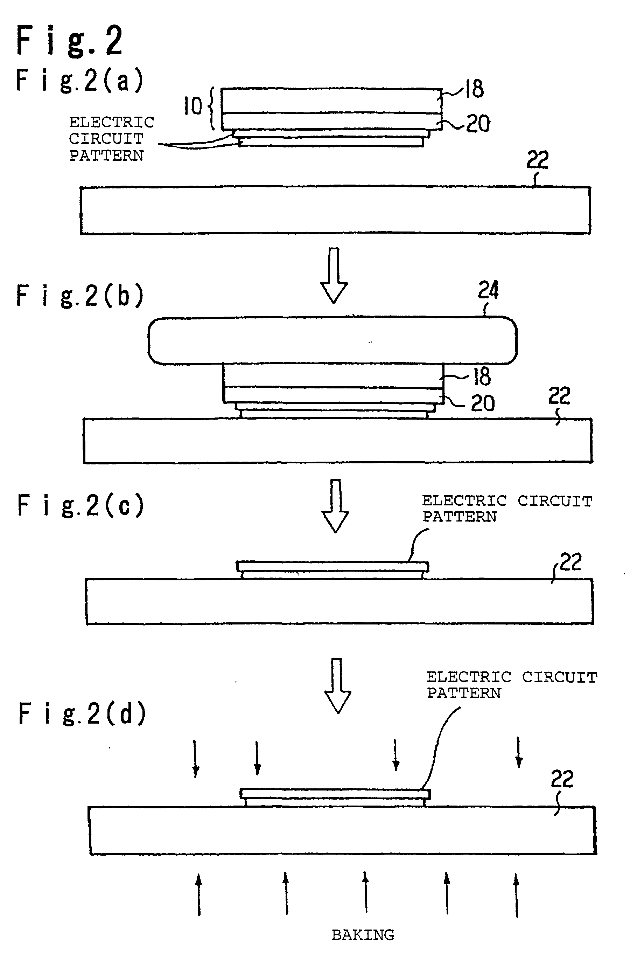

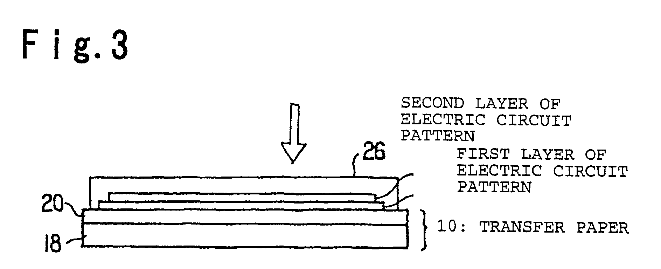

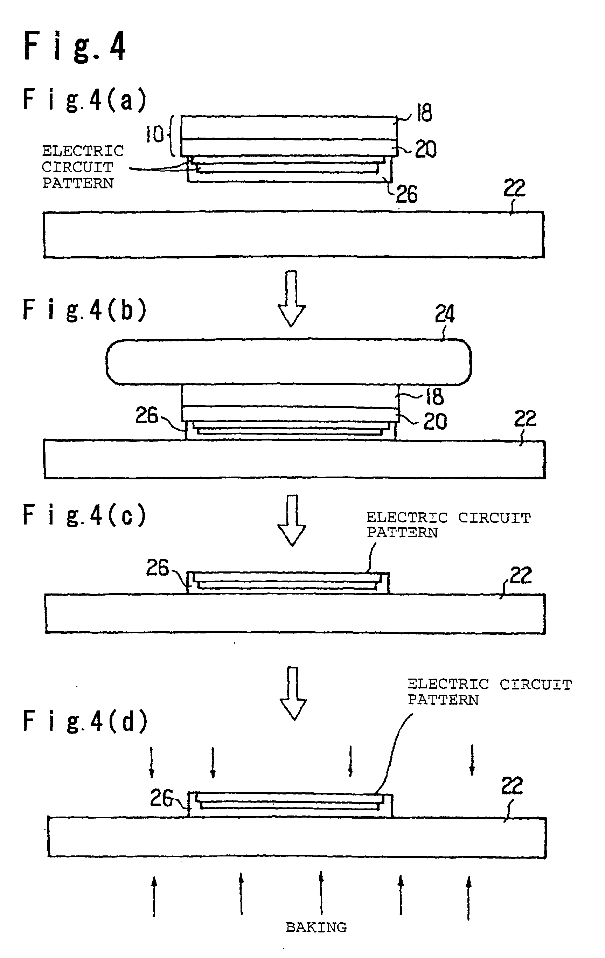

Figure 1 is a schematic diagram showing a case wherein desired electric circuit patterns are formed on a transfer paper in the method for forming a transfer type print pattern according to the present invention. Figure 2 is a process chart showing thermal transfer of an electric circuit patterns from the transfer paper shown in Figure 1 to a substrate. Figure 3 is a schematic view illustrating a case wherein desired electric circuit patterns are formed on a transfer paper, and an adhesion aid is formed, in the method for forming a transfer type print pattern according to the present invention. Figure 4 is a process chart showing thermal transfer of the electric circuit patterns from the transfer paper shown in Figure 3 to a substrate by means of the adhesion aid.

### BEST MODE FOR CARRYING OUT THE INVENTION

The transfer film in the present invention may be any film so long as it is a film having a release layer formed, which is an organic layer of e.g. silicon or acryl, and one having a release layer formed on a film such as paper, an organic film or a polymer film, may be employed. Such a transfer film is thin as compared with the substrate glass, whereby the cooling time at the time of heat drying a glass paste (such as a paste of electronic material) when screen printing is carried out on the transfer film, may be short, and the efficiency is high when electric circuit patterns, etc. are formed by multilayer printing. Therefore, the productivity can be made high. Further, the transfer film in the present invention is preferably a transfer paper.

Now, practical embodiments of the present invention (hereinafter referred to as practical embodiments) will be described with reference to the drawings taking as an example a case wherein the transfer film is a transfer paper.

Figures 1(a) and (b) show a schematic view illustrating a case where desired print patterns are formed on a transfer paper 10 in the method for forming a transfer type print pattern according to the present invention. In Figure 1(a), on a transfer paper 10, a print pattern such as an electric circuit pattern or a light-shielding pattern, is formed by a screen printing method. In the example shown in Figure 1(a) an electric circuit pattern to be formed on the transfer paper 10, is formed on a screen printing plate 12 to be used for the screen printing. The electric circuit pattern will be screen-printed on the transfer paper 10 by pushing out the electronic material paste 14 put on the screen printing plate 12 along an electric circuit pattern formed on the screen printing plate 12, by a squeegee 16. On the transfer paper 10, such screen printing is applied once or repeatedly a number of times, so that a flat or multi-layered electric circuit pattern (a print pattern) is formed.

Figure 1(b) shows a cross-sectional view of the transfer paper 10 having the electric circuit patterns thus formed by screen printing. In Figure 1(b), the transfer paper 10 has a double layered structure having a release layer 20 formed on a base material paper 18. Further, in the illustrated example, the electric circuit pattern is a multi-layered electric circuit pattern having a double layered structure comprising a first layer and a second layer.

By forming the release layer 20 on the base material paper 18 in such a manner, the electric circuit patterns formed on the transfer paper 10 will be readily peeled. This facilitates transfer of the electric circuit patterns from the transfer paper 10 to the substrate.

In the above-described screen printing, the electronic material paste 14 to be used for forming the electric circuit patterns is prepared by adjusting its composition by suitably mixing at least one member or all of members, selected from electronic material components consisting of a conductor, a semiconductor, a resistance material, an insulating material, a dielectric material and a magnetic material, depending upon the desired electric circuit and electronic element. Such a mixture is firstly processed into a powder and kneaded together with glass frit i.e. low melting powder glass powder, and a thermoplastic resin (an organic binder), to adjust the viscosity to a level suitable for screen printing. Here, the glass frit is one which softens and flows within a temperature range of the step of baking the substrate of e.g. glass or ceramics, and it is added for the purpose of bonding the substrate and the electronic material components for the electric circuit pattern.

On the other hand, the thermoplastic resin has a function to form the electronic material components and the glass frit into a paste state, but it also has a function to bond the electric circuit pattern to the substrate at the time of the thermal transfer and heat drying for screen printing. When the electric circuit patterns on the transfer paper 10 shown in Figures 1(a) and (b), are thermally transferred to the substrate, if the adhesion between the electronic material paste 14 to the substrate is not sufficient, in the subsequent step of baking by heat treatment, peeling will occur from the portion where the adhesion is insufficient. In order to secure this adhesion property, the above-mentioned thermoplastic resin is used. If this thermoplastic resin is one having a hot melt adhesive function, the adhesion property can further be improved.

From the foregoing, it is preferred to use a thermoplastic resin as an organic binder. Further, with a thermoplastic resin, gas bubbles generated when the resin is decomposed and evaporated during baking, can easily be removed. Also from this viewpoint, the thermoplastic resin is preferred, because such gas bubbles may present adverse effects to the properties and qualities of the electric circuit patterns after baking.

As the above thermoplastic resin, a thermoplastic polyester resin, a thermoplastic cellulose derivative, a thermoplastic acrylic resin or a thermoplastic vinyl acetate resin is preferred, and one member or a blend resin of two or more members, selected from them, may be employed. For example, a thermoplastic polyester resin such as polyethylene terephthalate, a thermoplastic cellulose derivative such as ethyl cellulose, a thermoplastic acrylic resin such as an acrylate copolymer or a methacrylate copolymer, or a thermoplastic vinyl acetate resin such as a homopolymer or copolymer of vinyl acetate, may be mentioned.

Further, a volatile solvent to be added at the time of preparation of the electronic material paste 14, is used to adjust the viscosity of the electronic material paste 14 to a viscosity suitable for screen printing. As a characteristic required for this volatile solvent, compatibility with the thermoplastic resin may be mentioned, and it is required to have a properly high boiling point so that the change with time of the viscosity property will be small.

The above-described electronic material paste 14 corresponds to the glass paste according to the present invention. The glass paste is not limited to the above electronic material paste 14, and it may be one containing, for example, an inorganic heat resistant pigment to form a light-shielding pattern instead of the electronic material such as a conductor.

Figure 2 shows a process for thermally transferring an electric circuit pattern from the transfer paper 10 having such an electric circuit pattern printed, as shown in Figure 1, to a substrate made of e.g. glass or ceramics. Here, the glass to be used for the substrate may be selected from a glass for automobiles, a glass for buildings and a glass for displays.

In Figure 2(a), electric circuit patterns formed on a release layer 20 of a transfer paper 10 are disposed to face the substrate 22 made of e.g. glass or ceramics, and as shown in Figure 2(b), the transfer paper 10 is pressed under a predetermined pressure by a pressing plate 24. At that time, heating is carried out simultaneously. The heating temperature is adjusted to be a temperature at which an adhesive property by the thermoplastic resin contained in the electronic material paste 14 constituting the electric circuit patterns, will develop. Further, the pressure exerted by the pressing plate 24 is controlled to a level where the electric circuit patterns will not deform when the electric circuit patterns are transferred.

By the above step, as shown in Figure 2(c), the electric circuit patterns are thermally transferred and bonded by the thermoplastic resin on the substrate 22. In this state, the electric circuit patterns do not have adequate circuit functions, because the thermoplastic resin is contained in the electric circuit patterns. Therefore, as shown in Figure 2(d), the substrate 22 is baked, so that the thermoplastic resin is removed by decomposition and evaporation, to develop the circuit functions.

In this baking step by such heat treatment, if there is a portion where the adhesion between the substrate 22 and the electric circuit patterns, is inadequate, air may be contained in such a portion. Further, gas bubbles will be generated also when the thermoplastic resin contained in the electric circuit patterns undergoes decomposition and evaporation. However, gas bubbles thereby formed can adequately be removed and will not present adverse effects to the circuit properties. Further, by using, for example, a thermoplastic polyester as such a thermoplastic resin, removal of such gas bubbles can effectively be carried out. Namely, the baking step is carried out at a temperature of from about 600 to 700°C. Whereas, the thermoplastic resin starts to decompose and evaporate at a temperature of e.g. in the vicinity of about 300°C or higher. In the case of a thermoplastic polyester resin, the decomposition and evaporation start, for example, at 440°C. At that time, the thermoplastic resin is in a molten state, and the gas bubbles generated will move in the thermoplastic resin in the molten state and will be released to the external space. Thus, the electric circuit patterns can adequately bonded to the substrate 22. Further, by heating the electric circuit patterns to a level of from 600 to 700°C, the glass frit contained in the electric circuit patterns will melt and bond to a substrate 22 made of e.g. glass, whereby integration with the substrate can be accomplished.

Further, when the above-described thermoplastic polyester resin or the like is used as the thermoplastic resin, since this resin has flexibility, it is possible to prevent peeling of the electric circuit patterns from the transfer paper 10 even when the transfer paper 10 is deformed when the electric circuit patterns are formed on the transfer paper 10.

Further, if an adhesive resin having an adhesive function, for example, an acrylic resin or the like excellent in combustibility, is coated as an adhesion aid on the electric circuit patterns formed on the above-mentioned transfer paper 10, the heating temperature at the time of transferring the electric circuit patterns onto the substrate 22, as shown in Figure 2(b), can be made low, or the pressing pressure at that time can be made low.

Figure 3 shows an example wherein an adhesion aid 26 is coated on the electric circuit patterns shown in Figure 1(b). In Figure 3, the adhesion aid 26 is printed and formed to cover the electric circuit patterns. Such an adhesion aid 26 can be used to sufficiently bond the electric circuit patterns to the substrate 22 in a case where a thermoplastic cellulose derivative having a weak adhesion to the glass or ceramic substrate 22 when formed into a paste, is used as an organic binder, or in a case where the adhesion is weak as the amount of the organic binder is small when made into a paste. Especially in the case of a thermoplastic cellulose derivative which is widely used for screen printing, it is preferred to employ the adhesion aid 26, since it will be required to set both the pressing pressure and the heating temperature to be high if transfer is carried out without using the adhesion aid 26, whereby it is likely to destroy the electric circuit patterns.

Figure 4 shows a process for thermally transferring the electric circuit patterns having the adhesive aid 26 formed thereon, as shown in Figure 3, from the transfer paper 10 to the substrate 22 made of e.g. glass or ceramics. In Figure 4(a), the electric circuit patterns covered with the adhesion aid 26 are disposed to face the substrate 22, and as shown in Figure 4(b) the transfer paper 10 is pressed under a predetermined pressure by a pressing plate 24. At that time, heating is carried out simultaneously, whereby the electric circuit patterns can be sufficiently bonded to the substrate 22 by the adhesive strength of the adhesion aid 26.

When a thermoplastic resin such as a thermoplastic cellulose derivative is used in an electronic material paste 14 as a material for the electric circuit patterns, such an adhesive aid 26 is required to have a heat decomposition temperature higher than the thermoplastic resin. As shown in Figure 4(c), the adhesion aid is present between the electric circuit patterns and the substrate 22, and if the heat decomposition temperature of the adhesion aid 26 is lower than the heat decomposition temperature of the thermoplastic resin in the electronic material paste 14, at the time of baking, the above thermoplastic resin in the electric circuit patterns is not decomposed, and release of the adhesion aid 26 already decomposed can not adequately be carried out, and during sintering, cracking or peeling is likely to result. Accordingly, when the thermal decomposition temperature of the adhesion aid 26 is represented by T₁, and the heat decomposition temperature of the thermoplastic resin in the electronic material paste 14 is represented by T₂, (T₁-T₂) is preferably from 5°C to 20°C. If less than 5°C, cracking or peeling is likely to result during sintering. If (T₁-T₂) exceeds 20°C, the thermal decomposition of the above thermoplastic resin tends to be too much, and it tends to be difficult to maintain the shape of the electric circuit patterns until the decomposition of the adhesion aid takes place. Further, (T₁-T₂) is more preferably from 5°C to 10°C. Outside this range, the possibility of cracking or peeling of the baked electric circuit patterns tends to be high.

Further, when the sintering initiation temperature of the electronic material paste 14 as the glass paste of the present invention, is represented by T₃, (T₃-T₁) is required to be at least 10°C, preferably at least 20°C. If (T₃-T₁) is lower than this, flowing and solidification of the electric circuit patterns are likely to start before the heat decomposition of the adhesion aid 26 takes place, whereby cracking or peeling is likely to result in the baked electric circuit patterns.

The foregoing phenomenon is remarkable when the thickness of the electric circuit patterns exceeds 20 µm, and it is preferred to control the heat decomposition temperatures of the adhesion aid and the thermoplastic resin (the organic binder) and the sintering initiation temperature of the glass paste. Here, the heat decomposition temperature is defined to be a temperature at which 98% of the weight of the test sample has decomposed when the temperature is raised at a rate of 20°C/min in the thermogravimetry. Further, the sintering initiation temperature is determined by baking the glass paste at various temperatures and examining the presence or absence of the sintering by visual observation.

The thickness of the layer of the above-described adhesion aid 26 is as thin as possible within a range where the adhesion property can be imparted, preferably from 1 to 3 µm. If it is less than 1 µm, no adequate adhesive property tends to be imparted, and if it exceeds 3 µm, it tends to take time for decomposition and release of the adhesion aid 26, thus leading to cracking or peeling of the baked electric circuit patterns.

According to the above-described method of the present invention, it is possible to transfer, as a print pattern, not only an electric circuit pattern, but also a dielectric print pattern, an insulator print pattern, a resistance material print pattern, a colored pattern, a light-shielding pattern or other functional layer of inorganic material. Further, it is possible to form a print pattern to a non-flat surface substrate, to which printing is difficult by direct printing onto the substrate by the screen printing method.

Specific examples of the method for forming a transfer type print pattern of the present invention, as described in the foregoing, will be explained as Working Examples. The following Examples 1 to 5 show cases wherein the print pattern is an electric circuit pattern. With respect to substrates 22 (200 × 100 mm; thickness: 3.5 mm) made of glass and having electric circuits formed, prepared in the following Examples 1 to 5, the resistivity (µΩ·cm), the tensile strength (kgf), the color difference (ΔE) and the quality were measured respectively. The results of the measurements are shown in Table 1. Their measuring methods will be described below. However, with respect to Examples 2 and 3, no measurement of the resistivity or tensile strength was carried out.

Resistivity: the electric resistance R was measured by means of a digital multimeter manufactured by ADVANTEST CORP. Further, the cross-sectional shape was measured by means of Surfcom (tradename), manufactured by TOKYO SEIMITSU CO., LTD., and the cross-sectional area S was calculated by integral calculus. Using the above R and S, R×S/L was calculated, and the calculated value was taken as the resistivity. Here, L is the length of the conductive line. The resistivity in a case where instead of the transfer by the method of the Examples of the present invention, printing was carried out directly on the glass substrate, followed by baking, was about 3.8. As compared with this value, if there is no remarkable change in the resistivity of the transferred conductor, the conductor (the conductive line) can be judged as well sintered.

A Sn-plated copper terminal bonded (bonded area: 25 mm²) by soldering to the conductor, was pulled by exerting a force, and the force when the Sn-plated copper terminal was peeled off, was measured by means of a small size tensile gauge. The present inventors have taken that more than 15 kgf is an allowable range. Namely, if the tensile strength is 15 kgf or higher, the conductor can be judged as well baked to the substrate.

Color difference: With respect to a square pattern portion of a conductive line of the conductor-attached glass plate obtained by the transfer by the method of this Example, the color difference ΔE (JIS Z8730 6.1) as observed from the side on which no conductive paste was printed and baked, was measured by means of a CR200 model spectrophotometer (tradename) manufactured by MINOLTA CO., LTD. A case where the color difference ΔE on the glass-baked surface is 1 or less as between one wherein the paste is printed and baked directly on the glass substrate and one prepared by the transfer, was taken as good substrate baking property. Further, also with respect to a non-conductor, the measurement was carried out in the same manner to confirm the good baked state to the substrate.

Quality: Presence or absence of formation of gas bubbles in the pattern after baking, was examined by visual observation. When no bubbles were present, it was judged that the circuit was well baked to the glass substrate.

### EXAMPLE 1

As an electronic material, a conductive material was used. A common conductive material may, for example, be a metal such as copper, aluminum, gold, silver or nickel, or a conductive oxide such as ITO, and any one of them may be employed. However, here, silver was used from the viewpoint of the high dielectric constant and easy availability of the material. As such silver, a flaky silver powder having a particle size of a few µm, was employed. As a low melting point glass powder (glass frit), a low melting point B₂O₃-SiO₂-PbO type glass frit having a melting point of not higher than the softening point of the soda lime silica glass for the substrate, was used. The composition of such a glass frit is shown in Table 1 as "Low melting point glass composition". As a thermoplastic resin (an organic binder) to form silver into a paste, a thermoplastic polyester resin which has a molecular weight of about 16000 and Tg (glass transition point) of about -25°C, was used. As a volatile solvent, cyclohexanone or BCA (butylcarbitol acetate: boiling point: about 150°C) was used. The above-described silver powder, the glass frit, the thermoplastic polyester resin and the volatile solvent (solvent) were mixed in the ratio as shown in Table 1 and kneaded by a mortar and a three-roll mill to obtain a paste.

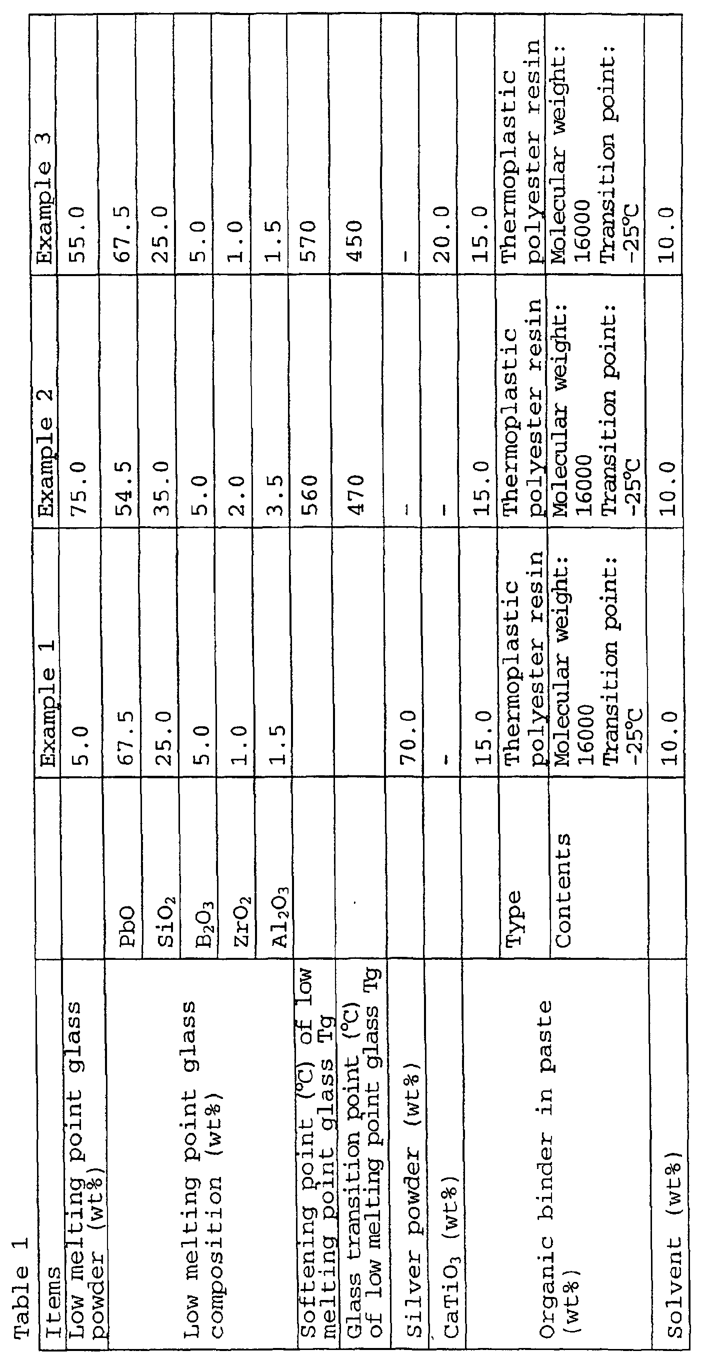

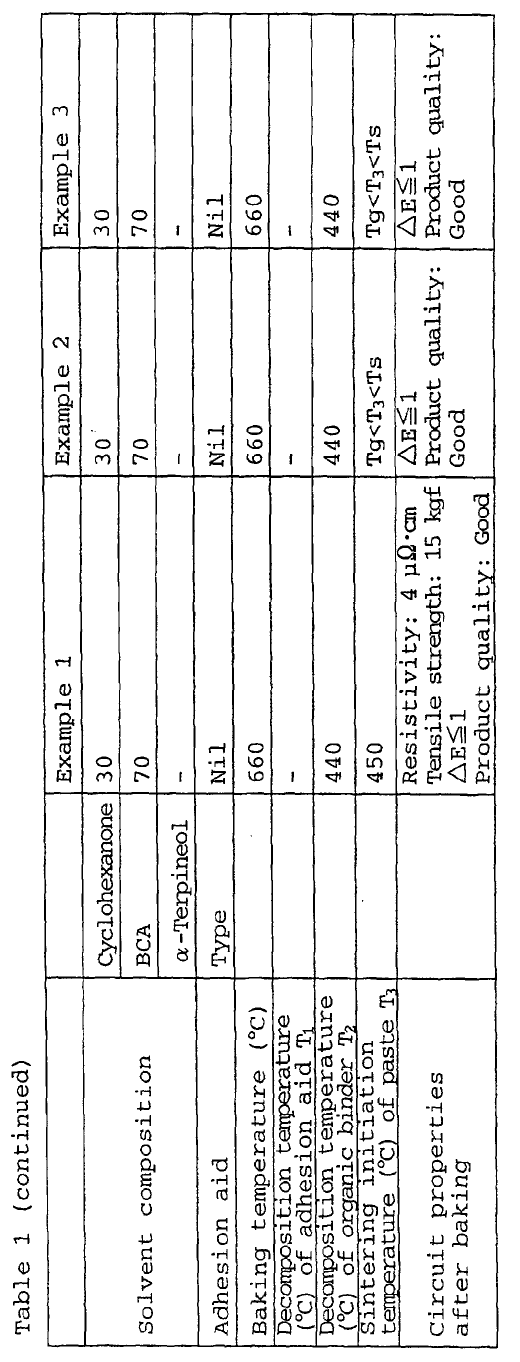

As the screen printing plate 12, a stainless steel mesh of 150 mesh having an emulsion thickness of 10 µm, was used. As the print pattern, a line having a length of 20 cm and a width of 1 mm was used.

As the transfer paper 10, one having a Si layer as a release layer 20 on its surface, was used. On the Si layer of the transfer paper 10, the prepared silver paste was screen-printed and dried at 120°C. Further, it was transferred onto a glass substrate at 180°C and baked at 660°C. In this Example, the heat decomposition temperature T₂ of the thermoplastic polyester resin was 440°C, while the sintering initiation temperature T₃ of the silver paste was 450°C. Thus, T₃ is higher by 10°C than T₂. Accordingly, heat decomposition of the thermoplastic polyester resin takes place before initiation of the sintering of the silver paste, and the silver paste sinters after the thermally decomposed gas has been released. Thus, there is little possibility that the baked print pattern undergoes cracking or peeling from the glass substrate. Here, the above sintering initiation temperature T₃ is a value obtained by baking the paste at various temperatures and examining the presence or absence of sintering by visual observation. Further, in this Example, no adhesion aid is used.

As shown in Table 1, it was possible to form on the glass substrate an electric circuit pattern which was excellent in all of the resistivity, the tensile strength and the baking characteristics (the color difference, the product quality) as a conductor after baking.

### EXAMPLE 2

As an electronic material, an insulating material was used. A common insulating material may be a low melting point glass or an oxide such as SiO₂, ZrO₂ or MgO. Any of such materials may be used, but, here, a low melting point glass powder was used taking into consideration the availability of the material and the adhesion to a glass for automobiles, as a substrate. As such a low melting point glass powder, one which is a B₂O₃-SiO₂-PbO type glass frit and which has a particle size of about a few µm, was used. The composition of this glass frit is also shown in Table 1 as "Low melting point glass composition".

To the above glass frit, a thermoplastic polyester resin and a volatile solvent were mixed in a ratio as shown in Table 1 to obtain a paste in the same manner as in Example 1. Then, this paste was used for screen printing on the transfer paper 10 and then dried. Thereafter, it was transferred onto a glass substrate and baked. In this Example, the heat decomposition temperature T₂ of the thermoplastic polyester resin was 440°C, while the sintering initiation temperature T₃ of the paste was inbetween the glass transition point of the glass frit Tg=470°C and the softening point Ts=560°C. Thus, T₃ was higher by at least 30°C than T₂, and like in Example 1, there is little possibility that the baked print pattern undergoes cracking or peeling from the glass substrate. Further, also in this Example, no adhesion aid is used.

As shown in Table 1, it was possible to form on the glass substrate an insulator excellent in the baking properties (the color difference, the product quality) after the transfer and baking.

### EXAMPLE 3

As an electronic material, a dielectric material was used. The dielectric material is included in an insulating material, but one having a high/low dielectric constant is particularly electrically effective. A common dielectric material may be a low melting point glass or an oxide such as SiO₂, ZrO₂, MgO, BaTiO₃, PbTiO₃, PbZrO₃, PbSrO₃ or CaTiO₃, and any one of them may be employed, but here, CaTiO₃ having a low dielectric constant characteristic was used. With CaTiO₃ alone, no adequate adhesion to the substrate glass can be secured. Accordingly, a B₂O₃-SiO₂-PbO type glass frit having a particle size of about a few µm, was mixed with CaTiO₃. The mixing ratio was as shown in Table 1. This material was formed into a paste in the same manner as in Example 1, which was screen-printed on the transfer paper 10 and dried. Thereafter, it was transferred onto a glass substrate and baked. Also in this Example, the heat decomposition temperature T₂ of the thermoplastic polyester resin was 440°C, and the sintering initiation temperature T₃ of the paste was inbetween the glass transition point of the glass frit Tg=450°C and the softening point Ts=570°C. Accordingly, like in Example 1, there is little possibility that the baked print pattern undergoes cracking or peeling from the glass substrate. Further, also in this Example, no adhesion aid is used.

As shown in Table 1, it was possible to form on the glass substrate an insulator excellent in the baking properties after the transfer and baking.

### EXAMPLE 4

In this Example, like in Example 1, a silver powder was used as an electronic material. Further, as a thermoplastic resin (an organic binder) to form the silver powder into a paste, ethylcellulose as a thermoplastic cellulose derivative, was used. These materials and a low melting point glass powder and a solvent were mixed in the ratio as shown in Table 2 and formed into a paste. This silver paste was used for screen printing on the transfer paper 10 and dried to form a print pattern. Then, an adhesion aid 26 shown in table 2 was printed in a thickness of 3 µm on the print pattern. The adhesive additive 26 is used to supplement the adhesive force of the print pattern, since the adhesive force of ethylcellulose used as an organic binder, is low. The adhesion aid 26 is an acrylic resin, and is one having a heat decomposition temperature T₁ which is higher by 5°C than the heat decomposition temperature T₂ (=375°C) of the ethylcellulose in the silver paste (T₁=380°C). Thereafter, it was transferred onto the glass substrate and baked at a temperature of 660°C.

As mentioned above, T₁ is higher by 5°C than T₂, and ethylcellulose is decomposed before the above acrylic resin during the baking. Therefore, ethylcellulose will be discharged from the print pattern composed by the silver paste to form pores, and the decomposition gas of the acrylic resin decomposed thereafter can readily be released through the pores, whereby cracking or peeling of the baked print pattern can be prevented.

Further, in this Example, the sintering initiation temperature T₃ of the silver paste is higher by 70°C than the above T₁, whereby the silver paste will sinter after decomposition and evaporation of the adhesion aid 26 has been sufficiently carried out. Thus, it is possible to prevent cracking or peeling of the print pattern.

As shown in Table 2, it was possible to form on the glass substrate an electric circuit pattern which was excellent in all of the resistivity, the tensile strength and the baking properties (the color difference, the product quality) as a conductor after the transfer and baking.

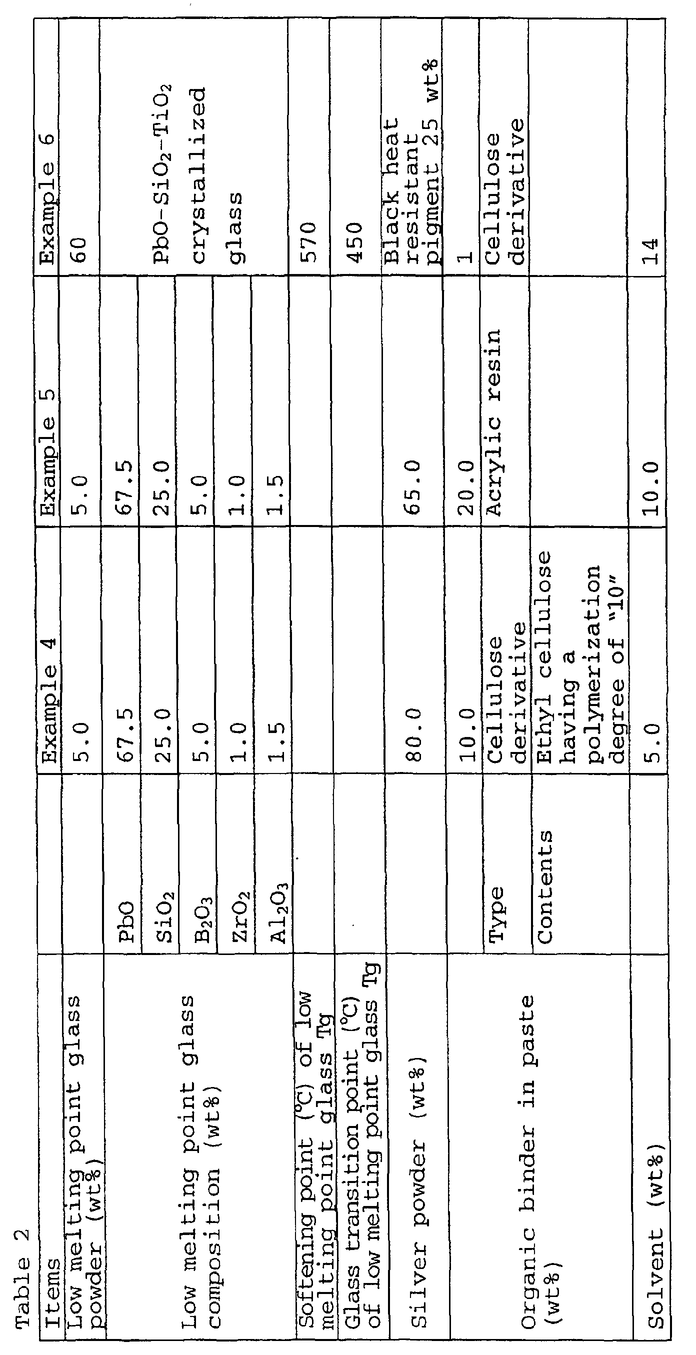

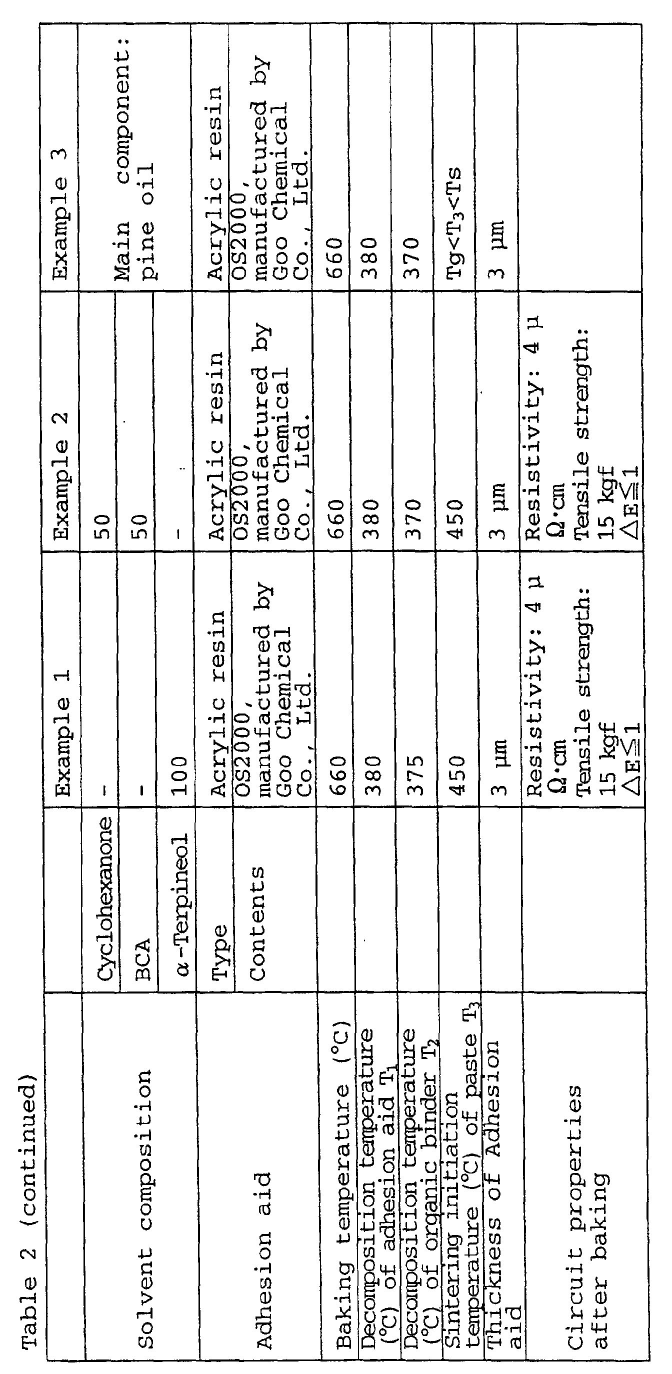

### EXAMPLE 5

In this Example, in the same manner as in Example 4, a silver powder was used as an electronic material. Further, a thermoplastic acrylic resin was used as a thermoplastic resin (an organic binder) to form the silver powder into a paste. These materials, and a low melting point glass powder and a volatile solvent (a solvent) were mixed in a ratio as shown in Table 2 to obtain a paste. This silver paste was used for screen printing on the transfer paper 10 and dried to form a print pattern. Then, in the same manner as in Example 4, an adhesion aid 26 shown in table 2 was printed in a thickness of 3 µm on the print pattern. Thereafter, it was transferred onto a glass substrate and baked.

The acrylic resin as an organic binder used in this Example was one different from the acrylic resin (OS2000, manufactured by Goo Chemical Co., Ltd.) used as the adhesion aid 26, and its heat decomposition temperature T₂ was 370°C. The heat decomposition temperature T₁ of the acrylic resin used as the adhesion aid 26 was 380°C and thus higher by 10°C than T₂. Accordingly, also in this Example, the organic binder is decomposed before the adhesion aid 26 during the baking. Thus, it is possible to prevent cracking or peeling of the baked print pattern.

Further, also in this Example, the sintering initiation temperature T₃ of the silver paste is higher by 70°C than the above T₁, whereby it is possible to prevent cracking or peeling of the baked print pattern.

As shown in Table 2, it was possible to form on the glass substrate an electric circuit pattern which was excellent in all of the resistivity, the tensile strength and the baking properties (the color difference, the product quality) as a conductor after the transfer and baking.

### EXAMPLE 6

In this Example, instead of an electronic material, a black inorganic heat resistant pigment was used, and a low melting point glass powder, a thermoplastic resin (an organic binder) and a solvent (a volatile solvent) were mixed thereto in a ratio as shown in Table 2, followed by forming into a paste to obtain a black ceramic paste. Here, as the low melting point glass powder, a PbO-SiO₂-TiO₂ crystallized glass was used, as shown in Table 2. Further, as the organic binder, a thermoplastic cellulose derivative was used.

The above black ceramic paste was used for screen printing on a transfer paper 10 and dried to form a print pattern. Then, in the same manner as in Example 4, an adhesive aid 26 shown in Table 2, was printed in a thickness of 3 µm on the print pattern. Thereafter, it was transferred onto a glass substrate and baked.

The heat decomposition T₂ of the thermoplastic cellulose derivative as an organic binder used in this Example, was 370°C, and the heat decomposition temperature T₁ of the acrylic resin as the adhesion aid 26, was 380°C. Accordingly, as T₁ is higher by 10°C than T₂, also in this Example, the thermoplastic resin is decomposed before the adhesion aid 26 during the baking. Thus, it is possible to prevent cracking or peeling of the baked print pattern.

Further, in this Example, the sintering initiation temperature T₃ of the black ceramic paste is inbetween the glass transition point of the low melting point glass powder Tg=450°C and the softening point Ts=570°C and higher by at least 70°C than the above T₁. Thus, it is also thereby possible to prevent cracking or peeling of the baked print pattern.

### INDUSTRIAL APPLICABILITY

As described in the foregoing, according to the present invention, it is possible to simply impart a print pattern such as a highly precise thin film electric circuit on a substrate having a large area to provide a functional glass, and it is possible to meet the demand for production of many product types in small amounts.

## Claims

1. A method for forming a transfer type print pattern, which comprises forming a print pattern on a transfer film by a glass paste, thermally transferring the print pattern onto a substrate, and baking the print pattern thermally transferred onto the substrate.

2. The method for forming a transfer type print pattern according to Claim 1, wherein the print pattern formed on the transfer film comprises at least one member selected from a conductive material, an insulating material, a dielectric material, a semiconductor material, a resistance material, a magnetic material and an inorganic heat-resistant pigment, and a thermoplastic resin which melts, decomposes and evaporates in the baking step.

3. The method for forming a transfer type print pattern according to Claim 2, wherein the thermoplastic resin is one member or a blend resin of two or more members, selected from a thermoplastic polyester resin, a thermoplastic cellulose derivative, a thermoplastic acrylic resin and a thermoplastic vinyl acetate resin.

4. The method for forming a transfer type print pattern according to any one of Claims 1 to 3, wherein the print pattern formed on the transfer film is in one layer or in a laminated structure of two or more layers.

5. The method for forming a transfer type print pattern according to any one of Claims 1 to 4, wherein the substrate is made of glass or ceramics.

6. The method for forming a transfer type print pattern according to any one of Claims 1 to 5, wherein an adhesion aid is preliminarily coated on the print pattern formed on the transfer film.

7. The method for forming a transfer type print pattern according to any one of Claims 1 to 5, wherein an adhesion aid is preliminarily coated on the print pattern formed on the transfer film, and when the decomposition temperature of the adhesion aid is represented by T₁, the decomposition temperature of the thermoplastic resin is represented by T₂ and the sintering initiation temperature of the glass paste is represented by T₃, (T₁-T₂) is from 5°C to 20°C, and (T₃-T₁) is 10°C or higher.

8. The method for forming a transfer type print pattern according to any one of Claims 1 to 7, wherein the print pattern is an electric circuit pattern.

9. A glass having a print pattern formed, wherein the print pattern is formed on one member selected from a glass for automobiles, a glass for buildings and a glass for displays, by the method for forming a transfer type print pattern according to any one of Claims 1 to 8.
